# EUROPEAN PATENT SPECIFICATION

(11) **EP 2 827 494 B1**
(45) Date of publication and mention of the grant of the patent: **18.09.2019**
(21) Application number: 14177186.5
(22) Date of filing: 16.07.2014
(51) Int. Cl.: H02S 40/34

(54) **Connection box**
Anschlussdose
Boîte de connexion

(30) Priority: 16.07.2013 CN 201320422428 U
(43) Date of publication of application: 21.01.2015
(73) Proprietor: Tyco Electronics (Shanghai) Co. Ltd., Shanghai 200233 (CN)
(72) Inventor: Wang, Shuzhi, 200233 Shanghai (CN)
(74) Representative: Grünecker Patent- und Rechtsanwälte PartG mbB

(56) References cited:
- EP-A2- 2 296 181
- DE-A1-102009 022 944
- JP-A- 2005 183 829
- US-A1- 2011 240 088

## Description

### BACKGROUND OF THE INVENTION

### Field of the Invention

The present invention relates to a connection box for connecting a cable, more particularly, relates to a connection box for connecting a cable of a photovoltaic module.

### Description of the Related Art

In an electronic system, for example, a solar energy photovoltaic module or a communication module, for transmitting weak electrical signals, it is necessary to transmit the weak electrical signals to an electrical device disposed inside connection box through a bus bar, converge the weak electrical signals and retransmit the converged weak electrical signals to an external electronic apparatus, for example, a photovoltaic current collector, through an external cable. In the prior art, inside the connection box generally are provided a plurality of connection terminals and at least one diode connected to the bus bar and the external cable.

In the prior art, the connection terminals and the diodes are connected generally in two connection types.

In one of the two connection types, two connection terminals are arranged parallel to each other, and the diode is connected between the two connection terminals. With this configuration, it may ensure there is an enough distance between a soldering point of the bus bar and pins of the diode. Thereby, a heat generated during soldering the bus bar is unlikely quickly transferred to the pins of the diode, and the diode is unlikely damaged due to the heat generated during soldering. However, with this configuration, the two connection terminals connecting both ends of the diode are arrange parallel to each other, it increases size of a body of the connection box in a width direction thereof, limiting the application of this connection box, for example, causing this connection box unsuitable for an assembly with a serious appearance requirement or a bifacial assembly.

In the other of the two connection types, two connection terminals and the diode are arranged in a length direction of the connection box, reducing the width size of the body of the connection box, but increasing the length size of the body of the connection box. Furthermore, this type of connection box cannot satisfy UL safety specifications, increasing the operation difficulty. US 2011/0240088 A1 discloses a connection box wherein terminals are provided which can be fixated to the box via molding. This process is complicated, expensive and permanent. DE 10 2009 022 944 A1 is related to a connection box, wherein terminals are permanently fixated to a backside of a photovoltaic module or to a bottom plate of the connection box by adhesive which flows through openings in the base portion of the terminal. For this process, a heating device is necessary which makes fixation of the terminal unnecessarily complicated. In EP 2 296 181 A2, terminals for connection boxes are shown, which are guided with guiding rails along a vertical direction for mounting on a backside of a photovoltaic module. The terminals are then soldered to the backside of the module. For providing the guiding rails, the terminals have to be formed with a complicated structure.

### SUMMARY OF THE INVENTION

The present invention has been made to overcome or alleviate at least one aspect of the above mentioned disadvantages.

According to an object of the present invention, there is provided a connection box with an extended heat conduction path between a first connection region for connecting a bus bar and a second connection region for connecting a diode.

According to an aspect of the present invention, there is provided a connection box for a photovoltaic module, comprising: a housing; at least one diode; and at least one pair of connection terminals. Each of the at least one diode is connected between one respective pair of connection terminals. Each connection terminal comprises: a base mounted on the housing; a first connection portion integrally connected with the base and provided with a first connection region for connecting with the diode; and a second connection portion electrically communicated with the base and provided with a second connection region for connecting with a bus bar, wherein a straight path between the first and second connection regions is disconnected, and wherein a plurality of deflectable barbs are formed on a bottom of the housing and configured to fix the base.

In the connection box according to the above exemplary embodiment of the present invention, a first installation hole and a second installation hole are formed in the base and arranged in a lateral direction.

In the connection box according to the above exemplary embodiment of the present invention, the first connection portion and the second connection portion extend substantially parallel to each other in a longitudinal direction from the same one side of the base; and a gap is defined between the first connection portion and the second connection portion.

In the connection box according to the above exemplary embodiment of the present invention, the first connection portion and the second connection portion are configured to be located in different planes.

In the connection box according to the above exemplary embodiment of the present invention, the first connection portion extends from a side of the base in a longitudinal direction, the second connection portion is bent from a side of the first connection portion and extends in a lateral direction away from the side of the first connection portion, and the first connection portion and the second connection portion are located in different planes.

In the connection box according to the above exemplary embodiment of the present invention, the first connection portion extends from a side of the base in a longitudinal direction, the second connection portion is bent from a side of the first connection portion and extends in a lateral direction approaching the first connection portion, and the first connection portion and the second connection portion are located in different planes.

In the connection box according to the above exemplary embodiment of the present invention, the first connection portion extends from a side of the base in a longitudinal direction, and the second connection portion is configured to have a substantial U-shape and comprises a first arm extending from a side of the first connection portion in a lateral direction away from the first connection portion and a second arm on which the second connection region is formed.

In the connection box according to the above exemplary embodiment of the present invention, the base comprises a first base and a second base; the first connection portion extends from a side of the first base in a longitudinal direction, and the second connection portion extends from a side of the second base in the longitudinal direction; and a bending portion is formed between the first and second connection portions.

In the connection box according to the above exemplary embodiment of the present invention, a first installation hole is formed in the first base, and a second installation hole is formed in the second base.

In the connection box according to the above exemplary embodiment of the present invention, a plurality of through holes are formed in the bottom of the housing and configured to permit bus bars to pass therethrough.

In the connection box according to the above exemplary embodiment of the present invention, a first installation post and a second installation post are formed on the bottom of the housing and configured to pass through the first installation hole and the second installation hole, respectively.

In the connection box according to the above exemplary embodiment of the present invention, a plurality of barbs are formed on the bottom of the housing and configured to fix the base.

In the connection box according to various exemplary embodiments of the present invention, since the straight path between the first and second connection regions is disconnected, heat generated in the second connection region is conducted to the first connection region through a bending heat conduction path. The heat conduction path between the first and second connection regions is extended. Thereby, heat conduction capability from the second connection region to the first connection region is decreased.

### BRIEF DESCRIPTION OF THE DRAWINGS

The above and other features of the present invention will become more apparent by describing in detail exemplary embodiments thereof with reference to the accompanying drawings, in which:
Fig.1 is an illustrative perspective view showing inside structure of a connection box according to a first exemplary embodiment of the present invention;
Fig.2 is an illustrative perspective view of a connection terminal of Fig. 1;
Fig.3 is an illustrative perspective view showing inside structure of a connection box according to a second exemplary embodiment of the present invention;
Fig.4 is an illustrative perspective view of a connection terminal of Fig.3;
Fig.5 is an illustrative perspective view showing inside structure of a connection box according to a third exemplary embodiment of the present invention;
Fig.6 is an illustrative perspective view of a connection terminal of Fig.5;
Fig.7 is an illustrative perspective view showing inside structure of a connection box according to a fourth exemplary embodiment of the present invention;
Fig. 8 is an illustrative perspective view of a connection terminal of Fig.7;
Fig.9 is an illustrative perspective view showing inside structure of a connection box according to a fifth exemplary embodiment of the present invention; and
Fig. 10 is an illustrative perspective view of a connection terminal of Fig.9.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided a connection box for a photovoltaic module, comprising: a housing; at least one diode; and at least one pair of connection terminals, wherein each of the at least one diode is connected between one respective pair of connection terminals, wherein each connection terminal comprises: a base mounted on the housing; a first connection portion integrally connected with the base and provided with a first connection region for connecting with the diode; and a second connection portion electrically communicated with the base and provided with a second connection region for connecting with a bus bar, a straight path between the first and second connection regions is disconnected.

A connection box in various exemplary embodiments of the present invention herein may be used to electrically connect a bus bar of an electronic system, such as, a photovoltaic module, for generating or transmitting weak electrical signals, so as to converge the weak electrical signals and retransmit the converged weak electrical signals to an external electronic apparatus, such as, a photovoltaic current collector through an external cable 10.

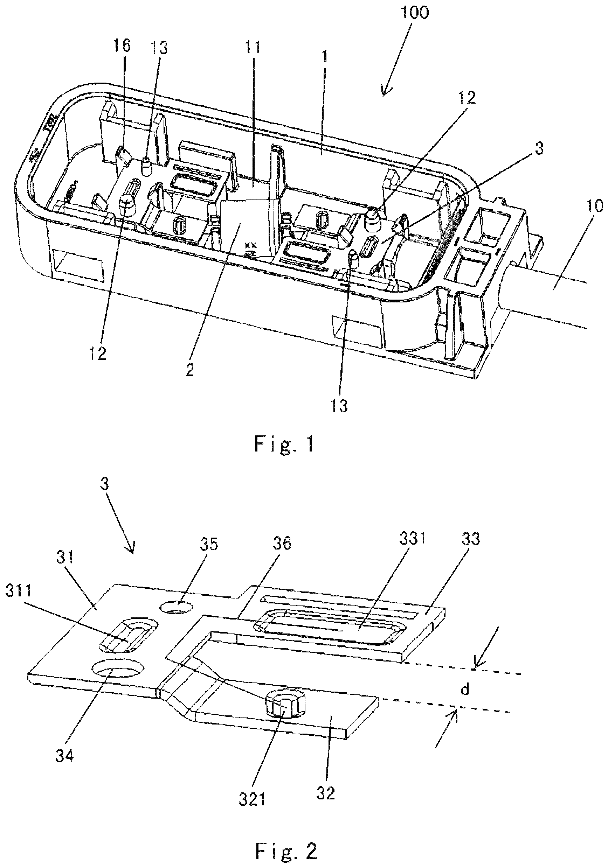

As shown in Figs. 1-2, in an exemplary embodiment of the present invention, the connection box 100 mainly comprise a housing 1 made of insulation material, at least one diode 2, and at least one pair of connection terminals 3. Each of the at least one diode 2 is connected between one respective pair of connection terminals 3. Each connection terminal mainly comprises a base 31 made of a conductive metal sheet, a first connection portion 32 and a second connection portion 33. The base 31 is mounted on the housing 1. The first connection portion 32 is integrally connected with the base 31 and provided with a first connection region 321 for connecting with the diode 2. The second connection portion 33 is electrically communicated with the base 31 and provided with a second connection region 331 for connecting with a bus bar (not shown). A straight path between the first and second connection regions 321 and 331 is disconnected, that is, a straight heat conduction path from the second connection region 331 to the first connection region 321 is disconnected. Thereby, a heat generated in the second connection region 331 cannot be conducted to the first connection region 321 through the straight path, so that the heat generated in the second connection region 331 is conducted to the first connection region 321 through a bending heat conduction path.

Referring to Fig.2, a first installation hole 34 and a second installation hole 35 are formed in the base 31 and arranged in a lateral direction. Correspondingly, as shown in Fig.1, a first installation post 12 and a second installation post 13 are formed on an bottom of the housing 1 and configured to pass through the first installation hole 34 and the second installation hole 35, respectively. Also, a plurality of barbs 16 are formed on the bottom of the housing 1 and configured to fix the base 31. During installation, the first and second installation holes are aligned to the first and second installation posts, respectively, and the corresponding barbs 16 are abutted against the edge of the base 31 at the same time, then the base 31 is pushed down to force the barbs 16 to deflect outside. After the base 31 is installed in place, the barbs 16 restore to their original states and fix the entire connection terminal 3 in the housing 1.

Also, please refer to Fig.2, the first connection portion 32 and the second connection portion 33 extend substantially parallel to each other in a longitudinal direction (a length direction of the connection box) from the same side of the base 31. A gap d is defined between the first connection portion 32 and the second connection portion 33. Thereby, in a plan view, the first connection portion 32 and the second connection portion 33 exhibit a substantial U-shape. The first connection portion 32 and the second connection portion 33 are configured to be located in different planes. In an alternative exemplary embodiment, the first connection portion 32, the second connection portion 33 and the base 31 may be located in the same one plane.

As shown in Fig.1, the paired connection terminals 3 are disposed in such an arrangement that the first connection portion 32 of one of the paired connection terminals 3 is opposite to the second connection portion 33 of the other of the paired connection terminals 3. In this way, the first connection portions 32 and the second connection portions 33 of the paired connection terminals 3 are arranged to be diagonally opposite to each other. Since two pins of the diode 2 are connected to the first connection regions 321 on the first connection portions 32 of the pair of connection terminals 3, respectively, so that the diode 2 is arranged to be angled with respect to a longitudinal axis of the connection box.

A cable 10, for example connected to an external electronic apparatus, passes through a through hole formed in the housing 1 and is electrically connected to a third connection region 311 on the base 31 of one of the pair of connection terminals 3 by, for example, soldering. A third connection region on the base 31 of the other of the pair of connection terminals 3 is left unused. A plurality of through holes (not shown) are formed in the bottom of the housing 1 and configured to permit bus bars (not shown) to pass therethrough. The bus bars, for example from photovoltaic modules, pass through the respective through holes and are soldered to the second connection regions on the second connection portions of the other of the pair of connection terminals. In this way, an electrical connection of the photovoltaic module to the external electronic apparatus can be achieved by use of the connection box of the present invention. In an exemplary embodiment, for facilitating the connection, the first connection region 321, the second connection region 331 and the third connection region 311 each is formed with a recess feature.

In the connection box 100 according to the first exemplary embodiment of the present invention, the straight path between the second connection region 331 for connecting the bus bar and the first connection region 321 for connecting the diode is disconnected, that is, the straight heat conduction path from the second connection region 331 to the first connection region 321 is disconnected. Thereby, the heat generated in the second connection region 331 cannot be conducted to the first connection region 321 along the straight path. During connecting the bus bar to the second connection region 331 by, for example, soldering, the heat generated in the second connection region 331 due to soldering the bus bar is conducted to the first connection region 321 only along a substantially U-shaped bending heat conduction path 36. In this way, the heat conduction path between the second connection region 331 and the first connection region 321 is extended, decreasing the heat conduction capability from the second connection region to the first connection region, and protecting the diode 2 from being damaged or failed due to the heat generated during soldering the bus bar.

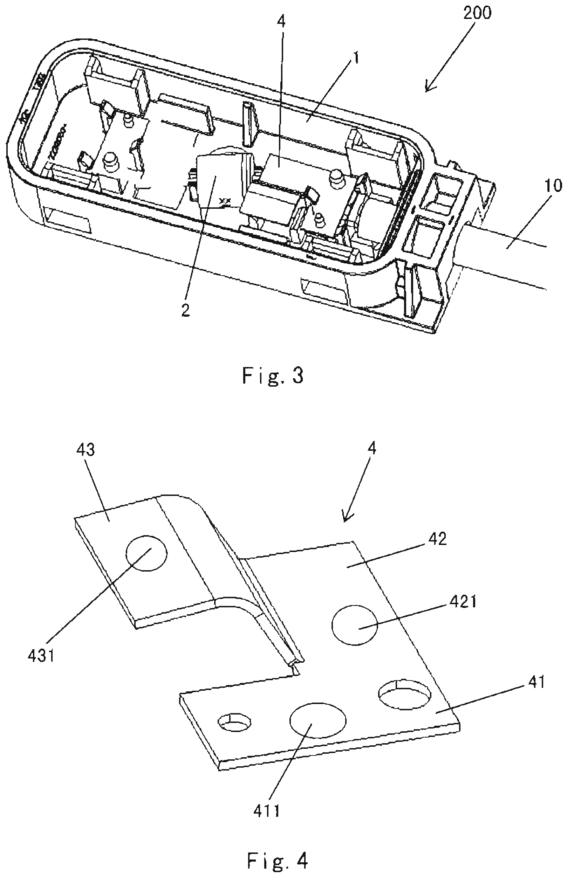

Fig.3 is an illustrative perspective view showing inside structure of a connection box 200 according to a second exemplary embodiment of the present invention; Fig.4 is an illustrative perspective view of a connection terminal 4 of Fig.3.

The housing 1 of the connection box 200 according to the second embodiment is configured to be the same as the housing 1 of the connection box 100 according to the first embodiment.

Referring to Figs.3-4, in the connection box 200 according to the second embodiment, each connection terminal 4 mainly comprises a base 41 made of a conductive metal sheet, a first connection portion 42 and a second connection portion 43. The base 41 is mounted on the housing 1. The first connection portion 42 is integrally connected with the base 41 and provided with a first connection region 421 for connecting with a diode. The second connection portion 43 is electrically communicated with the base 41 and provided with a second connection region 431 for connecting with a bus bar (not shown). A straight path between the first and second connection regions 421 and 431 is disconnected, that is, a straight heat conduction path from the second connection region 431 to the first connection region 421 is disconnected. Thereby, a heat generated in the second connection region 431 cannot be conducted to the first connection region 421 through the straight path.

In the connection terminal 4 according to the second embodiment, the first connection portion 42 extends from a side of the base 41 in a longitudinal direction (a length direction of the connection box 200), and the second connection portion 43 is bent from a side of the first connection portion 42 and extends in a lateral direction away from the side of the first connection portion 42. The first connection portion 42 and the second connection portion 43 are located in different planes. Thereby, in a plan view, the first connection portion 42 and the second connection portion 43 exhibit a substantial Z-shape. Two installation holes are formed in the base 41. A cable 10, for example connected to an external electronic apparatus, passes through a through hole formed in the housing 1 and is electrically connected to a third connection region 411 on the base 41 of one of a pair of connection terminals 4 by, for example, soldering. A third connection region on the base 41 of the other of the pair of connection terminals 4 is left unused.

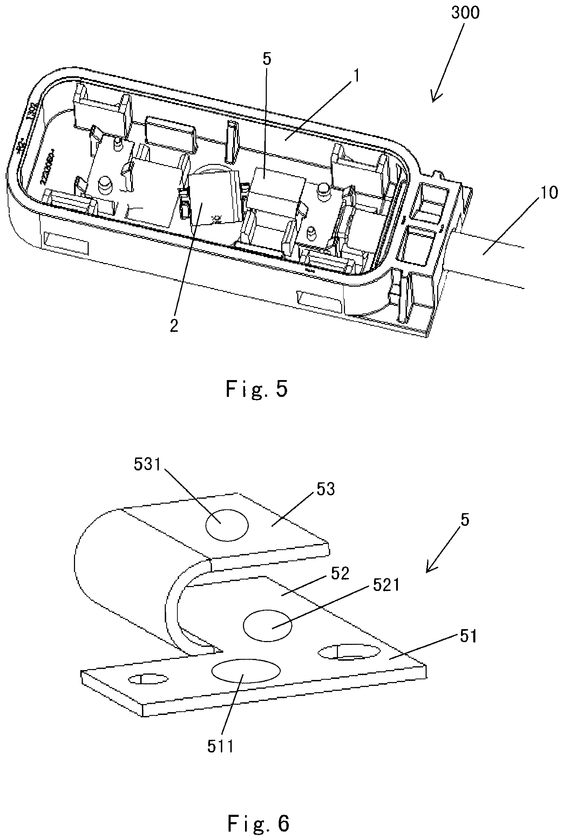

Fig.5 is an illustrative perspective view showing inside structure of a connection box 300 according to a third exemplary embodiment of the present invention; Fig.6 is an illustrative perspective view of a connection terminal 5 of Fig.5.

The housing 1 of the connection box 300 according to the third embodiment is configured to be the same as the housing 1 of the connection box 100 according to the first embodiment.

Referring to Figs.5-6, in the connection box 300 according to the third embodiment, each connection terminal 5 mainly comprises a base 51 made of a conductive metal sheet, a first connection portion 52 and a second connection portion 53. The base 51 is mounted on the housing 1. The first connection portion 52 is integrally connected with the base 51 and provided with a first connection region 521 for connecting with a diode. The second connection portion 53 is electrically communicated with the base 51 and provided with a second connection region 531 for connecting with a bus bar (not shown). A straight path between the first and second connection regions 521 and 531 is disconnected, that is, a straight heat conduction path from the second connection region 531 to the first connection region 521 is disconnected. Thereby, a heat generated in the second connection region 531 cannot be conducted to the first connection region 521 through the straight path.

In the connection terminal 5 according to the third embodiment, the first connection portion 52 extends from a side of the base 51 in a longitudinal direction (a length direction of the connection box 300), the second connection portion 53 is bent from a side of the first connection portion 52 and extends in a lateral direction approaching the first connection portion 52, and the first connection portion 52 and the second connection portion 53 are located in different planes. Thereby, in a side view, the first connection portion 52 and the second connection portion 53 exhibit a substantial U-shape. Two installation holes are formed in the base 51. A cable 10, for example connected to an external electronic apparatus, passes through a through hole formed in the housing 1 and is electrically connected to a third connection region 511 on the base 51 of one of a pair of connection terminals 5 by, for example, soldering. A third connection region on the base 51 of the other of the pair of connection terminals 5 is left unused.

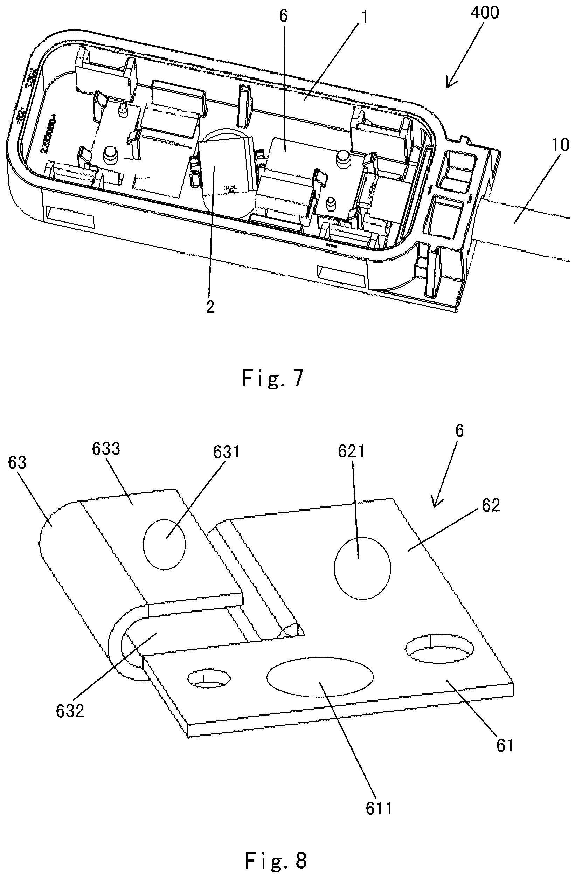

Fig.7 is an illustrative perspective view showing inside structure of a connection box 400 according to a fourth exemplary embodiment of the present invention; Fig.8 is an illustrative perspective view of a connection terminal 6 of Fig.7.

The housing 1 of the connection box 400 according to the fourth embodiment is configured to be the same as the housing 1 of the connection box 100 according to the first embodiment.

Referring to Figs.7-8, in the connection box 400 according to the fourth embodiment, each connection terminal 6 mainly comprises a base 61 made of a conductive metal sheet, a first connection portion 62 and a second connection portion 63. The base 61 is mounted on the housing 1. The first connection portion 62 is integrally connected with the base 61 and provided with a first connection region 621 for connecting with a diode. The second connection portion 63 is electrically communicated with the base 61 and provided with a second connection region 631 for connecting with a bus bar (not shown). A straight path between the first and second connection regions 621 and 631 is disconnected, that is, a straight heat conduction path from the second connection region 631 to the first connection region 621 is disconnected. Thereby, a heat generated in the second connection region 631 cannot be conducted to the first connection region 621 through the straight path.

In the connection terminal 6 according to the fourth embodiment, the first connection portion 62 extends from a side of the base 61 in a longitudinal direction (a length direction of the connection box 400). The second connection portion 63 is configured to have a substantial U-shape and comprises a first arm 632 extending from a side of the first connection portion 62 in a lateral direction away from the first connection portion 62 and a second arm 633 on which the second connection region 331 is formed. Thereby, in a side view, the first arm 632 and the second arm 633 of the second connection portion 63 exhibit a substantial U-shape. Two installation holes are formed in the base 61. A cable 10, for example connected to an external electronic apparatus, passes through a through hole formed in the housing 1 and is electrically connected to a third connection region 611 on the base 61 of one of a pair of connection terminals 6 by, for example, soldering. A third connection region on the base 61 of the other of the pair of connection terminals 6 is left unused.

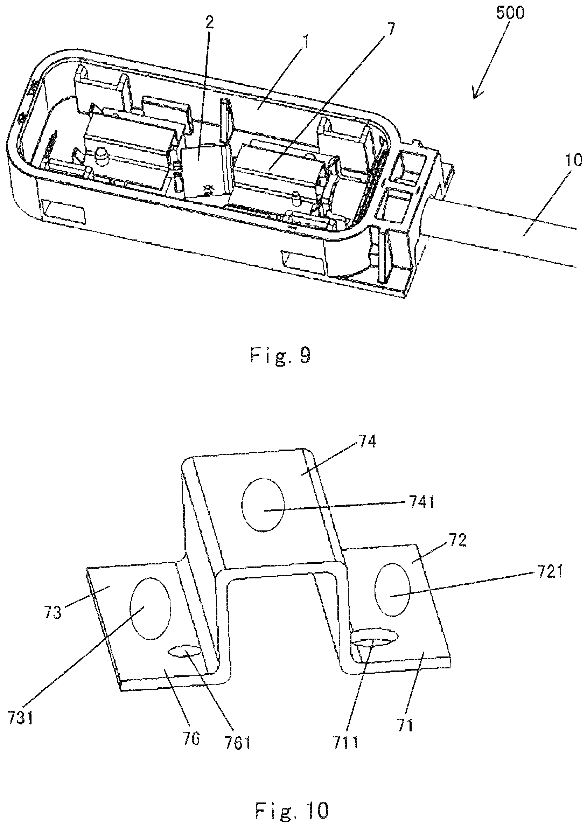

Fig.9 is an illustrative perspective view showing inside structure of a connection box 500 according to a fifth exemplary embodiment of the present invention; Fig. 10 is an illustrative perspective view of a connection terminal 7 of Fig.9.

The housing 1 of the connection box 500 according to the fifth embodiment is configured to be the same as the housing 1 of the connection box 100 according to the first embodiment.

Referring to Figs.9-10, in the connection box 500 according to the fifth embodiment, each connection terminal 7 mainly comprises a base comprising a first base 71 and a second base 76 and made of a conductive metal sheet, a first connection portion 72 and a second connection portion 73. The first base 71 and the second base 76 are mounted on the housing 1. The first connection portion 72 is integrally connected with the first base 71 and provided with a first connection region 721 for connecting with a diode. The second connection portion 73 is electrically communicated with the second base 76 and provided with a second connection region 731 for connecting with a bus bar (not shown). A straight path between the first and second connection regions 721 and 731 is disconnected, that is, a straight heat conduction path from the second connection region 731 to the first connection region 721 is disconnected. Thereby, a heat generated in the second connection region 731 cannot be conducted to the first connection region 721 through the straight path.

In the connection terminal 7 according to the fifth embodiment, the base comprises the first base 71 and the second base 76. The first connection portion 72 extends from a side of the first base 71 in a longitudinal direction, and the second connection portion 73 extends from a side of the second base 76 in the longitudinal direction. A bending portion 74 is formed between the first and second connection portions 72 and 73. A first installation hole 711 is formed in the first base 71, and a second installation hole 761 is formed in the second base 76. A cable 10, for example connected to an external electronic apparatus, passes through a through hole formed in the housing 1 and is electrically connected to a third connection region 741 on the bending portion 74 of one of a pair of connection terminals 7 by, for example, soldering. A third connection region on the bending portion of the other of the pair of connection terminals 7 is leaved unused.

In the various exemplary embodiments of the present invention, a miniaturized connection box can be achieved. The connection terminal can be formed by cutting, bending and punching a single metal sheet. The straight heat conduction path from the second connection region to the first connection region is disconnected, and the heat generated in the second connection region cannot be conducted to the first connection region through the straight path. Thereby, the heat generated in the second connection region is conducted to the first connection region through the bending heat conduction path, extending the heat conduction path, decreasing the heat conduction capability from the second connection region to the first connection region, protecting the diode from being damaged or failed due to the heat during soldering the bus bar, achieving the miniaturized connection box, improving the performances of the electrical devices in the connection box, and keeping cost from being increased due to maintenance, rework and exchange of the electrical devices.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles of the disclosure, the scope of which is defined in the claims.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. A connection box (100) for a photovoltaic module, comprising:
a housing (1);
at least one diode (2); and
at least one pair of connection terminals (3), each of the at least one diode (2) being electrically connected between one respective pair of connection terminals (3), wherein each connection terminal comprises:
a base (31) mounted on the housing (1);
a first connection portion (32) integrally connected with the base (31) and provided with a first connection region (321) for connecting with the diode (2); and
a second connection portion (33) electrically communicated with the base (31) and provided with a second connection region (331) for connecting with a bus bar,
wherein a straight path between the first and second connection regions (321, 331) is disconnected,
and wherein a plurality of deflectable barbs (16) are formed on a bottom of the housing (1) and configured to fix the base (31).

2. The connection box according to claim 1,
wherein a first installation hole (34) and a second installation hole (35) are formed in the base (31) and arranged in a lateral direction.

3. The connection box according to claim 1,
wherein the first connection portion (32) and the second connection portion (33) extend substantially parallel to each other in a longitudinal direction from the same one side of the base (31); and
a gap is defined between the first connection portion (32) and the second connection portion (33).

4. The connection box according to claim 3,
wherein the first connection portion (32) and the second connection portion (33) are configured to be located in different planes.

5. The connection box according to claim 1,
wherein the first connection portion (42) extends from a side of the base in a longitudinal direction (41),
the second connection portion (43) is bent from a side of the first connection portion (42) and extends in a lateral direction away from the side of the first connection portion (42), and
the first connection portion (42) and the second connection portion (43) are located in different planes.

6. The connection box according to claim 1,
wherein the first connection portion (52) extends from a side of the base in a longitudinal direction (51),
the second connection portion (53) is bent from a side of the first connection portion (52) and extends in a lateral direction approaching the first connection portion (52), and
the first connection portion (52) and the second connection portion (53) are located in different planes.

7. The connection box according to claim 1,
wherein the first connection portion (62) extends from a side of the base in a longitudinal direction (61), and
the second connection portion (63) is configured to have a substantial U-shape and comprises a first arm (632) extending from a side of the first connection portion (62) in a lateral direction away from the first connection portion (62) and a second arm (633) on which the second connection region (331) is formed.

8. The connection box according to claim 1,
wherein the base comprises a first base (71) and a second base (76);
the first connection portion (72) extends from a side of the first base (71) in a longitudinal direction, and the second connection portion (73) extends from a side of the second base (76) in the longitudinal direction; and
a bending portion (74) is formed between the first and second connection portions (72, 73).

9. The connection box according to claim 8,
wherein a first installation hole (711) is formed in the first base (71), and a second installation hole (761) is formed in the second base (76).

10. The connection box according to claim 1,
wherein a plurality of through holes are formed in a bottom of the housing (1) and configured to permit bus bars to pass there through.

11. The connection box according to claim 2,
wherein a first installation post (12) and a second installation post (13) are formed on the bottom of the housing (1) and configured to pass through the first installation hole (34) and the second installation hole (35), respectively.

## Patentansprüche

1. Anschlusskasten (100) für ein Photovoltaik-Modul, der umfasst:
ein Gehäuse (1);
wenigstens eine Diode (2); sowie
Wenigstens ein Paar Verbindungsanschlüsse (3), wobei jede der wenigstens einen Diode (2) elektrisch zwischen ein entsprechendes Paar von Verbindungsanschlüssen (3) geschaltet ist und jeder Verbindungsanschluss umfasst:
einen Sockel (31), der an dem Gehäuse (1) angebracht ist;
einen ersten Verbindungsabschnitt (32), der integral mit dem Sockel (31) verbunden und mit einem ersten Verbindungsbereich (321) zum Verbinden mit der Diode (2) versehen ist; sowie
einen zweiten Verbindungsabschnitt (33), der elektrisch mit dem Sockel (31) in Verbindung steht und mit einem zweiten Verbindungsbereich (331) zum Verbinden mit einer Sammelschiene versehen ist,
wobei ein gerader Weg zwischen dem ersten und dem zweiten Verbindungsbereich (321, 331) geteilt ist,
und eine Vielzahl biegbarer Haken (16) an einem Boden des Gehäuses (1) ausgebildet und zum Fixieren des Sockels (31) eingerichtet sind.

2. Anschlusskasten nach Anspruch 1,
wobei ein erstes Installations-Loch (34) und ein zweites Installations-Loch (35) in dem Sockel (31) ausgebildet und in einer seitlichen Richtung angeordnet sind.

3. Anschlusskasten nach Anspruch 1,
wobei sich der erste Verbindungsabschnitt (32) und der zweite Verbindungsabschnitt (33) im Wesentlichen parallel zueinander in einer Längsrichtung von der gleichen einen Seite des Sockels (31) aus erstrecken; und
ein Zwischenraum zwischen dem ersten Verbindungsabschnitt (32) und dem zweiten Verbindungsabschnitt (33) ausgebildet ist.

4. Anschlusskasten nach Anspruch 3,
wobei der erste Verbindungsabschnitt (32) und der zweite Verbindungsabschnitt (33) so eingerichtet sind, dass sie in verschiedenen Ebenen angeordnet sind.

5. Anschlusskasten nach Anspruch 1,
wobei sich der erste Verbindungsabschnitt (42) von einer Seite des Sockels aus in einer Längsrichtung (41) erstreckt,
der zweite Verbindungsabschnitt (43) von einer Seite des ersten Verbindungsabschnitts (42) gebogen ist und sich in einer seitlichen Richtung von der Seite des ersten Verbindungsabschnitts (42) weg erstreckt, und
der erste Verbindungsabschnitt (42) und der zweite Verbindungsabschnitt (43) in verschiedenen Ebenen angeordnet sind.

6. Anschlusskasten nach Anspruch 1,
wobei sich der erste Verbindungsabschnitt (52) von einer Seite des Sockels aus in einer Längsrichtung (51) erstreckt,
der zweite Verbindungsabschnitt (53) von einer Seite des ersten Verbindungsabschnitts (52) gebogen ist und sich in einer seitlichen Richtung auf den ersten Verbindungsabschnitt (52) zu erstreckt, und
der erste Verbindungsabschnitt (52) und der zweite Verbindungsabschnitt (53) in verschiedenen Ebenen angeordnet sind.

7. Anschlusskasten nach Anspruch 1,
wobei sich der erste Verbindungsabschnitt (62) von einer Seite des Sockels aus in einer Längsrichtung (61) erstreckt, und
der zweite Verbindungsabschnitt (63) so eingerichtet ist, dass er im Wesentlichen U-förmig ist, und einen ersten Arm (632), der sich von einer Seite des ersten Verbindungsabschnitts (62) aus in einer seitlichen Richtung von dem ersten Verbindungsabschnitt (62) weg erstreckt, sowie einen zweiten Arm (633) umfasst, an dem der zweite Verbindungsbereich (331) ausgebildet ist.

8. Anschlusskasten nach Anspruch 1,
wobei der Sockel einen ersten Sockel (71) und einen zweiten Sockel (76) umfasst;
der erste Verbindungsabschnitt (72) sich von einer Seite des ersten Sockels (71) aus in einer Längsrichtung erstreckt, und der zweite Verbindungsabschnitt (73) sich von einer Seite des zweiten Sockels (76) aus in der Längsrichtung erstreckt; und
ein Biegeabschnitt (74) zwischen dem ersten und dem zweiten Verbindungsabschnitt (72, 73) ausgebildet ist.

9. Anschlusskasten nach Anspruch 8,
wobei ein erstes Installations-Loch (711) in dem ersten Sockel (71) ausgebildet ist und ein zweites Installations-Loch (761) in dem zweiten Sockel (76) ausgebildet ist.

10. Anschlusskasten nach Anspruch 1,
wobei eine Vielzahl von Durchgangslöchern in einem Boden des Gehäuses (1) ausgebildet und so eingerichtet sind, dass sie zulassen, dass Sammelschienen durch sie hindurchtreten.

11. Anschlusskasten nach Anspruch 2,
wobei ein erster Installations-Zapfen (12) und ein zweiter Installations-Zapfen (13) an dem Boden des Gehäuses (1) ausgebildet und so eingerichtet sind, dass sie durch das erste Installations-Loch (34) bzw. das zweite Installations-Loch (35) hindurchtreten.

## Revendications

1. Boîte de connexion (100) pour un module photovoltaïque, comprenant:
un logement (1);
au moins une diode (2); et
au moins une paire de bornes de connexion (3), chacune de ladite au moins une diode (2) étant connectée électriquement entre une paire respective de bornes de connexion (3), dans lequel chaque borne de connexion comprend:
une base (31) montée sur le logement (1);
une première partie de connexion (32) connectée de manière intégrale à la base (31) et munie d'une première zone de connexion (321) destinée à être connectée à la diode (2); et
une seconde partie de connexion (33) en communication électrique avec la base (31) et munie d'une seconde zone de connexion (331) destinée à être connectée à une barre omnibus,
dans lequel un trajet rectiligne entre les première et seconde zones de connexion (321, 331) est déconnecté,
et dans lequel une pluralité de barbes pouvant être déviées (16) sont formées sur un fond du logement (1) et configurées pour fixer la base (31).

2. Boîte de connexion selon la revendication 1,
dans lequel un premier trou d'installation (34) et un second trou d'installation (35) sont formés dans la base (31) et agencés dans une direction latérale.

3. Boîte de connexion selon la revendication 1,
dans lequel la première partie de connexion (32) et la seconde partie de connexion (33) s'étendent sensiblement parallèlement l'une à l'autre dans une direction longitudinale à partir du même côté de la base (31); et
un espace est défini entre la première partie de connexion (32) et la seconde partie de connexion (33).

4. Boîte de connexion selon la revendication 3,
dans lequel la première partie de connexion (32) et la seconde partie de connexion (33) sont configurées pour être situées dans des plans différents.

5. Boîte de connexion selon la revendication 1,
dans lequel la première partie de connexion (42) s'étend depuis un côté de la base dans une direction longitudinale (41),
la seconde partie de connexion (43) est pliée depuis un côté de la première partie de connexion (42) et s'étend dans une direction latérale à l'opposé du côté de la première partie de connexion (42), et
dans lequel la première partie de connexion (42) et la seconde partie de connexion (43) sont configurées pour être situées dans des plans différents.

6. Boîte de connexion selon la revendication 1,
dans lequel la première partie de connexion (52) s'étend depuis un côté de la base dans une direction longitudinale (51),
la seconde partie de connexion (53) est pliée depuis un côté de la première partie de connexion (52) et s'étend dans une direction latérale s'approchant de la première partie de connexion (52), et
dans lequel la première partie de connexion (52) et la seconde partie de connexion (53) sont situées dans des plans différents.

7. Boîte de connexion selon la revendication 1,
dans lequel la première partie de connexion (62) s'étend depuis un côté de la base dans une direction longitudinale (61),
la seconde partie de connexion (63) est configurée pour avoir une forme substantielle en U et comprend un premier bras (632) s'étendant depuis un côté de la première partie de connexion (62) dans une direction latérale éloignée de la première partie de connexion (62) et un second bras (633) sur lequel la second zone de connexion (331) est formée.

8. Boîte de connexion selon la revendication 1,
dans lequel la base comprend une première base (71) et une seconde base (76);
la première partie de connexion (72) s'étend depuis un côté de la première base (71) dans une direction longitudinale et la seconde partie de connexion (73) s'étend depuis un côté de la seconde base (76) dans la direction longitudinale; et
une partie de pliage (74) est formée entre le première partie et la seconde partie de connexion (72, 73).

9. Boîte de connexion selon la revendication 8,
dans lequel un premier trou d'installation (711) est formé dans la première base (71) et un second trou d'installation (761) est formé dans la seconde base (76).

10. Boîte de connexion selon la revendication 1,
dans lequel une pluralité de trous traversants sont formés dans un fond du logement (1) et configurés pour permettre le passage de barres omnibus.

11. Boîte de connexion selon la revendication 2,
dans lequel un premier poteau d'installation (12) et un second poteau d'installation (13) sont formés sur le fond du logement (1) et configurés pour passer à travers le premier trou d'installation (34) et le second trou d'installation (35), respectivement.
